# EUROPEAN PATENT APPLICATION

(11) **EP 1 246 261 A2**
(43) Date of publication of application: **02.10.2002**
(21) Application number: 02252182.7
(22) Date of filing: 26.03.2002
(51) Int. Cl.: H01L 31/18, H01L 31/068

(54) **Space solar cell**

(30) Priority: 27.03.2001 JP 2001090605
(71) Applicant: Nagoya Institute of Technoloy, Nagoya-shi, Aichi 466-8555 (JP); NATIONAL SPACE DEVELOPMENT AGENCY OF JAPAN, Minato-ku Tokyo (JP)
(72) Inventor: Umeno, Masayoshi, Nagoya, Aichi 465-0084 (JP); Soga, Tetsuo, Nagoya, Aichi 458-0015 (JP); Imaizumi, Mitsuru, Ichinomiya, Aichi 491-0913 (JP)
(74) Representative: Rackham, Stephen Neil

(57) **Abstract**

Disclosed is a solar cell for use in space, comprising compound semiconductors used as photovoltaic conversion material. The solar cell comprises a cover glass (01) used for improving the radiation tolerance as a substrare for thin film deposition. The solar cell further comprises a crystalline thin film of the compound semiconductors (03,04,05) formed on a surface of the cover glass (01) for acting as the photovoltaic conversion material. The crystalline thin film of compound semiconductors (03,04,05) are formed using a metal organic chemical vapor deposition system.

## Description

The present invention relates to solar cells for use in space comprising compound semiconductors, and more particularly, for improvement in performance and reduction in manufacturing cost for such solar cells.

A solar cell or solar array has commonly been used as the main power source in a man-made satellite in space. The solar cell dedicated for use in space is produced using compound semiconductors of Group Ill-V compounds, for example, GaAs. For such solar cells, a crystalline thin film formed on a single-crystalline semiconductor substrate such as GaAs using a metal-organic vapor phase deposition system is commonly used. Furthermore, in order to suppress any degradation in performance of the solar cell due to the presence of high energy cosmic rays such as electrons, protons, etc., in space, a high energy particle protection plate of glass, called "a cover glass", is usually attached to a surface of the solar cells with an adhesive for improving the radiation tolerance of the solar cells.

In such compound semiconductor type solar cells, the single-crystalline semiconductor substrate occupies the major part of the weight of the solar cells, but it does not contribute to photovoltaic conversion performance of the solar cells at all because of high absorption coefficient of 111-V materials. In such sense, the semiconductor substrate in the prior art solar cell is functionally useless, which is a major factor to impede realization of thinner and lighter solar cells. On the other hand, the single-crystalline semiconductor substrate is expensive, which adds the manufacturing cost of the solar cells. In addition, because of a step for attaching the cover glass involved in the assembly process for the solar cell arrays, such step obstructs reduction in manufacturing cost of the solar cell arrays. Furthermore, the adhesive for the cover glass is defective in that it increases the weight of the solar cell arrays.

In view of the above, an object of the present invention is to provide a compound semiconductor solar cells for space that has lighter weight, requires lower manufacturing cost and improves the radiation tolerance.

To attain such object the present invention provides a compound semiconductor type solar cells for use in space, comprising a cover glass used as a substrate, and crystalline thin films of compound semiconductor directly formed on a cover glass.

In one embodiment of the present invention said crystalline thin film of a compound semiconductor is formed using a metal organic chemical vapor deposition system. The term "crystalline" is used herein to mean either single-crystal" or "polycrystalline".

Preferably said crystalline thin film of compound semiconductors is formed from Group Ill-V elements using a metal organic chemical vapor deposition system.

In another embodiment said crystalline thin films of the compound semiconductor is formed at the temperature range of approx. 400°C to 600°C.

Preferably said crystalline thin films of the compound semiconductor is formed at the temperature range of approx. 450°C to 550°C.

In manufacturing process of the solar cell according to the present invention a cover glass is provided, instead of the conventional semiconductor substrate. Then, a thin film of semiconductor acting as a photovoltaic conversion element is formed on a surface of the cover glass using a metal organic chemical vapor deposition system (MOCVD). In this connection the cover glass acting as the substrate is required to be heated for thermally decomposable thin film growth materials of semiconductors. To avoid deterioration or softening of the glass occurred if the temperature is too high it is necessary to precisely control the substrate temperature in a MOCVD system. In general the glass starts to soften when the temperature exceeds approx. 600 °C, therefore, the temperature of the substrate in a MOCVD system is required to be kept less than approx. 600°C, and more preferably, less than approx. 550°C. On the other hand, if the temperature is too low, decomposition of the semiconductor crystal growth material is impeded, therefore, the substrate temperature is required to be kept over at least approx. 400°C, and more preferably, over 450°C. This temperature range is relatively lower, as compared to the conventional process where the thin film is formed on the semiconductor substrate at the temperature ranging from approx. 600°C to approx. 800°C.

In such manner, the cover glass is used, in place of the conventional semiconductor substrate, which can dispense with the single-crystal semiconductor substrate and the adhesive for the cover glass used in the prior art. Accordingly the weight of the solar cell can significantly be reduced as well as the manufacturing cost. According to the present invention the semiconductor thin film is formed with the cover glass, which completely eliminates the step for attaching cover glass in the prior art. This can further reduce the manufacturing cost of the solar cell.

Now, the present invention will be described with reference to the accompanying drawings, in which:
Fig. 1 is a cross section view illustrating the construction of a compound semiconductor type solar cell for use in space constructed according to one embodiment of the present invention;
Fig. 2 is a graph showing an X-ray diffraction spectrum measured on a multi-layered film of crystalline compound semiconductors used for manufacturing the compound semiconductor type solar cell in Fig. 1;
Fig. 3 is a graph showing the relation between light absorption coefficient and photon energy measured on the multi-layered film of the crystalline compound semiconductor used for manufacturing the compound semiconductor type solar cell in Fig. 1;
Fig. 4 is a graph showing a current-voltage characteristic for the compound semiconductor type solar cell according to one embodiment of the present invention; and
Fig. 5 is a graph showing a radiation degradation characteristic for the compound semiconductor type solar cell when it is irradiated with 1 MeV electrons.

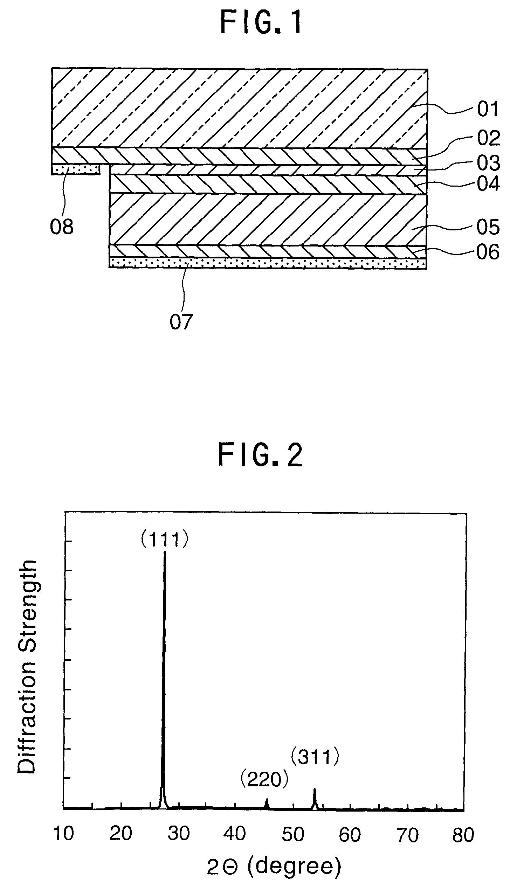

Fig. 1 is a cross section view illustrating the structure of a compound semiconductor type solar cell for use in space constructed according to one embodiment of the present invention. Instead of using conventional semiconductor substrates, the solar cell in this embodiment includes a cover glass 01 used as a substrate, that is in the form of a square plate having the dimension of 2cm x 2cm and the thickness of 150 µm. The cover glass 01 is one that is available from Pilkington PLC in United Kingdom under the model name of "CMG" and that has the same thermal expansion coefficient as GaAs. The composition of the cover glass typically includes boron in 5.2%; oxygen in 51%; sodium in 3.7%; aluminum in 1.4%; and silicon in 38.8%. In addition, the cover glass has physical characteristics including distorting point of approx. 510°C (that means the maximum temperature in normal usage over which any deterioration starts) and softening point of approx. 720°C (over which any deformation starts).

One side of the cover glass 01 on which the thin film compound semiconductors is formed has already been provided with an electrically conductive and transparent layer 02 of zinc oxide used as an electrode of the solar cell. On such transparent conductive layer 02 of the cover glass 01 the following layers are sequentially formed: n⁺ - AlGaAs crystalline semiconductor layer 03; n⁺ - GaAs crystalline semiconductor layer 04; p-GaAs crystalline semiconductor layer 05; and p⁺ - GaAs crystalline semiconductor layer 06 ("+" means that the carrier density is higher), thereby configuring solar cell. The n⁺ - AlGaAs crystalline semiconductor layer 03 has the thickness of approx. 0.1 µm and the carrier density of approx. 2x10^{19 cm-3}. The n⁺ - GaAs crystalline semiconductor layer 04 has the thickness of approx. 0.3 µm and the carrier density of approx. 5x10¹⁸ cm⁻³. The p-GaAs crystalline semiconductor layer 05 has the thickness of approx. 2.0 µm and the carrier density of approx. 2x10¹⁶ cm⁻³. The p⁺ - GaAs crystalline semiconductor layer 06 has the thickness of approx. 02 µm and the carrier density of approx. 2x10¹⁹ cm⁻³. A p-side metal electrode 07 of Au-Ge/Ni/Au is formed entirely on the p⁺ - GaAs crystalline semiconductor layer 06. The metal electrode 7 also acts as a reflection layer for the light that is not absorbed, but is transmitted thereto. In addition, a n-side metal electrode 08 of Au is formed on the zinc oxide layer 02 at the end portion thereof. The solar cell having the configuration as above is used as so called "a superstrate type" in which the light is incident on the front surface of the cover glass. It is noted that the thickness of each of the semiconductor layers in Fig. 1 is not illustrated in the real scale.

Process for manufacturing the compound semiconductor type solar cell for use in space will be described in more detail hereafter.

First of all the cover glass 01 having one side dimension of 2 inch in diameter and thickness of 150 µm and having a zinc oxide layer 02 formed on one side thereof is degreased by washing it with solutions including an organic solvent such as acetone and then sulfuric acid added with hydrogen peroxide. Thereafter, the both surfaces of the cover glass are etched using a hydrogen fluoride solution.

After the washing for degreasing and the etching, the cover glass 01 is placed on a graphite susceptor in a reactor of a metal-organic chemical vapor deposition system (MOCVD) with the zinc oxide layer 02 faced upwardly. Then a radio frequency heating system is operated to heat the susceptor for increasing the temperature of the cover glass to the desired substrate temperature. Next, the sequential growth of n⁺ - AlGaAs crystalline semiconductor layer 03; n⁺ - GaAs crystalline semiconductor layer 04; p-GaAs crystalline semiconductor layer 05; and p⁺ - GaAs crystalline semiconductor layer 06 is performed. The n-type and p-type dopants are Se and Zn, respectively, and the time period required for growth of the layers is determined depending on the thickness of the layers. After completion of growth of the layers, the reactor is cooled down to the ambient temperature and the resultant product is removed from the MOCVD system. It is desired that the substrate temperature is set at some temperature that is lower than the distorting temperature over which the physical characteristics of the cover glass such as light transmittivity starts to change. In this example the substrate temperature is set at 500°C.

Fig. 2 is a graph showing an X-ray diffraction spectrum measured on the semiconductor multi-layered film produced by the MOCVD system, as described above. As can be seen in the graph, a diffraction line (111) is shown as having higher strength. This is due to the polycrystaliline film mainly oriented to (111) direction. Therefore, the semiconductor multi-layered film has the crystalline characteristic, instead of amorphous characteristic.

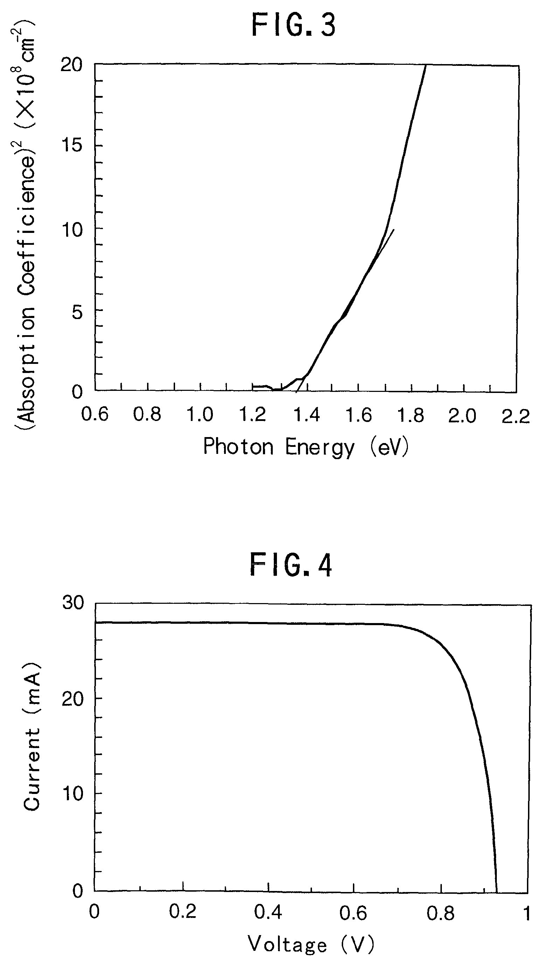

Fig. 3 is a graph showing the relation between light absorption coefficient (squared value) and optical band gap derived from the wavelength dependency of light reflection and light transmission measured on the multilayered film. Because of very thin of the n⁺ - AlGaAs crystalline semiconductor layer 03 it may be considered that the graph in Fig. 3 substantially shows the relation between light absorption coefficient and the optical band gap for the GaAs layers 04 to 06. The value of the optical band gap estimated from the threshold of the light absorption coefficient (squared value) is approx. 1.35 eV, which is considered preferable for a solar cell material.

Thereafter, the p-side metal electrode 07 having Au/Ni/Au-Ge construction is formed entirely on the surface of the p⁺ - GaAs crystalline semiconductor layer 06 using the vacuum evaporation system. Then, an annealing process is conducted at the temperature of approx. 400°C for a period of approx. 15 min. to reduce contact resistance between metal and semiconductor. Next, a pattern is produced for forming the electrodes on the front side by a conventional photolithography. Then, an end portion of the crystalline semiconductor multi-layered film is partially etched using an etching solution including the mixture of phosphoric acid, hydrogen peroxide and pure water. Evaporation process is then used to produce the n-side electrode 08 made from Au. Fig. 4 is a graph showing a current-voltage characteristic for the compound semiconductor type solar cell according to the present invention, as measured under such condition that it is irradiated with "AMO simulated sunlight" (of 136.7 mW/cm²) at the cell temperature of 28°C. The data such as the open-circuit voltage of 931mV, the short-circuit current density of 27.9 mA/cm² and the fill factor of 78.2% are derived, which provides a conversion efficiency of approx. 15.0%.

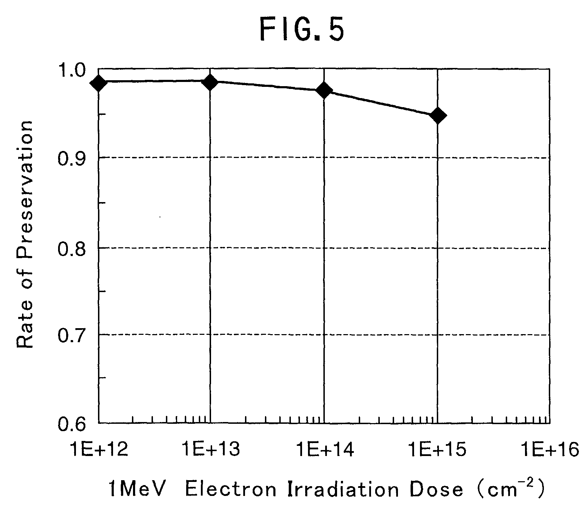

Fig. 5 is a graph showing the remaining factor of the maximum output power (or the ratio of deteriorated value to the initial value) for the compound semiconductor type solar cell according to the present invention, as measured after irradiated with an electron ray of 1 MeV. The remaining factor at the irradiation dose of 1x10¹⁵ cm⁻² is 95%, and the output power at that time is equal to that of the conventional single-crystalline GaAs solar cell at the irradiation dose of 1x10¹⁵ cm⁻².

Thus, one embodiment of the present invention has been described in detail with reference to the drawings. The present invention is, however, not limited to such embodiment, but it may be implemented in other several ways.

For instance, the present invention has been described with respect to the solar cell formed from the compound semiconductors such as GaAs and A1GaAs. However, the present invention may additionally be applied to the solar cell formed from another compound semiconductors such as InP, InGaP, InGaAs, GaN, ZnSe, etc.

In the embodiment as above, the "MOCVD" system has been used to produce the multi-layered film of the crystalline compound semiconductors of the solar cell. Of course, other thin film growth process such as a molecular beam epitaxial growth system may be used. Furthermore, the structure of the multi-layered film of the compound semiconductors on the solar cell may be modified to have another structure such as that for so called tandem type solar cell where there is two or more p-n junctions provided therein.

## Claims

1. A solar cell for use in space, comprising compound semiconductors (03,04,05) used as photovoltaic conversion material, **characterized in that** it comprises:
a cover glass (01) used for improving the resistance to radiation characteristic of the solar cell; and,
a crystalline thin film of the compound semiconductors (03,04,05) formed on the cover glass for acting as the photovoltaic conversion material.

2. A solar cell according to claim 1 in which said crystalline thin film of the compound semiconductors is formed using a metal-organic chemical vapor deposition system.

3. A solar cell according to claim 1 or 2 in which said crystalline thin film of the compound semiconductors is formed from Group III-V elements using a metal organic chemical vapor deposition system.

4. A solar cell according to claim 3 in which said crystalline thin film of the compound semiconductors is formed at the temperature range of approx. 400°C to 600°C.

5. A solar cell according to claim 3 in which said crystalline thin film of the compound semiconductors is formed at the temperature range of approx. 500°C to 550°C.

6. A solar cell according to any one of the preceding claims, in which a transparent conductive layer (02) is interposed between the compound semiconductors (03,04,05) and the cover glass (01).
